# EUROPEAN PATENT SPECIFICATION

(11) **EP 3 933 897 B1**
(45) Date of publication and mention of the grant of the patent: **17.05.2023**
(21) Application number: 20923924.3
(22) Date of filing: 20.11.2020
(51) Int. Cl.: H01L 21/56, H01L 23/13, H01L 23/31, H01L 23/498

(54) **PACKAGING STRUCTURE AND FORMATION METHOD THEREFOR**
VERPACKUNGSSTRUKTUR UND HERSTELLUNGSVERFAHREN DAFÜR
STRUCTURE D'ENCAPSULATION ET SON PROCÉDÉ DE FORMATION

(30) Priority: 13.03.2020 CN 202010174461
(43) Date of publication of application: 05.01.2022
(73) Proprietor: Changxin Memory Technologies, Inc., Hefei, Anhui 230601 (CN)
(72) Inventor: ZHANG, Zhiwei, Hefei, Anhui 230601 (CN)
(74) Representative: V.O.
(86) International application number: PCT/CN2020/130381
(87) International publication number: WO 2021/179672

(56) References cited:
- JP-A- S58 171 815
- US-A1- 2002 111 016
- US-A1- 2003 042 035
- US-A1- 2011 193 228
- US-A1- 2012 048 607
- US-A1- 2013 273 694
- US-A1- 2019 067 037
- US-B1- 6 519 844
- US-B1- 6 519 844
- US-B1- 9 129 978
- US-B2- 6 772 512

## Description

This application claims priority to Chinese Patent Application No. 202010174461.6, filed on March 13, 2020 and entitled with "PACKAGED STRUCTURE AND FORMING METHOD THEREOF".

### TECHNICAL FIELD

The present invention relates to the field of chip packaging, and in particular, to a packaged structure and a forming method thereof.

### BACKGROUND

After a chip is packaged, it needs to be wrapped through an injection molding process to protect the chip.

A chip packaged in a flipping manner (i.e., a "flip-chip") is connected to a circuit on a substrate using solder balls. In an injection packaging process, the chip needs to be wrapped by a plastic packaging material to fill with the gap between the chip and the substrate. Because the chip is directly connected to the substrate through the solder balls or other solder bumps, the gap between the chip and the substrate is relatively small, so is the spacing between connection points. Therefore, air may be trapped when the gap is filled with the plastic packaging material. As such, air bubbles may be formed in the plastic packaging material between the chip and the substrate, thereby affecting the stability of the flip-chip. For example, air bubbles trapped in the plastic packaging material can expand/contract due to thermal expansion, causing the flip-chip to separate from the substrate.

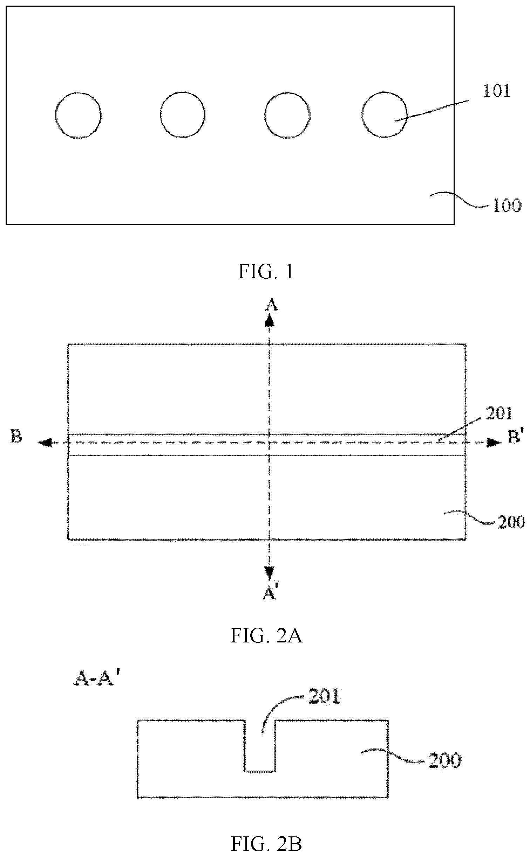

In existing techniques, to facilitate the gas removal in the injection molding process, a plurality of air holes may be provided in the packaged substrate, so that gas may be removed through the air holes in the substrate during the filling of plastic packaging material in the injection molding process. Referring to FIG. 1, it is a schematic top view of a substrate 100 having air holes 101 in existing techniques. A plurality of air holes may be formed in the substrate to achieve a better gas removal efficiency. Since most of the area on the substrate is used to connect to a chip, the area that can be used to form the air holes is relatively small. When a large number of air holes are formed, the size of each of the air holes is relatively small. Although the number of gas removal positions can be increased by increasing the number of air holes, the improvement to the gas removal efficiency is limited because the air holes are small and are prone to be blocked by the plastic packaging material. Additionally, since the air holes penetrate through the substrate and occupy the area used to form a circuit in the substrate, they hinder the circuit design in the substrate. Particularly, the number and distribution position of the solder balls formed on the back surface of the substrate may be greatly affected by the air holes, resulting in a reduced connection region on the back surface of the substrate. Related technologies are known from documents US 2019/067037 A1 and US6519844 B1.

In particular, US 2019/067037 A1 discloses a packaged structure, comprising:
a substrate having a first surface and a second surface opposite to each other, the first surface having at least one strip-shaped groove having one end extending to an edge of the substrate and open to exterior, a depth of the groove being smaller than a thickness of the substrate;
a chip fastened onto the first surface of the substrate in a flipping manner by using solder bumps and electrically connected to the substrate through the solder bumps, at least a portion of the groove located within a projection of the chip on the substrate;
a bottom filling layer filling a gap between the chip and the first surface of the substrate, wherein the groove has a continuous gas path formed in the groove.

Therefore, there is an urgent need to eliminate residual gas in the packaged structure without affecting the connection region on the back surface of the substrate of a packaged chip in the injection molding process.

### SUMMARY

The technical problem to be resolved in the present invention is to provide a packaged structure and a forming method thereof to improve the reliability of the packaged structure without adversely affecting the connection region on the back surface of a substrate.

The invention is defined by the independent claims.

According to the packaged structure provided in the present invention, the groove having two ends open to the exterior is formed in the first surface of the substrate to remove gas in the process of forming the bottom filling layer. In addition, the depth of the groove is smaller than the depth of the substrate, so that the distribution of metal wires and solder balls on the second surface of the substrate is not affected, thereby improving the utilization rate of the second surface of the substrate.

The width of the groove is smaller than the fillable width of the bottom filling layer, so that the bottom filler cannot fill the groove in the injection molding process, thereby preventing the groove from being blocked and improving the gas removal efficiency of the groove.

### BRIEF DESCRIPTION OF DRAWINGS

FIG. 1 is a schematic top view of a substrate having a plurality of air holes, in accordance with existing techniques.
FIG. 2A to FIG. 2C are schematic structural views of the substrate of a packaged structure according to an embodiment of the present invention.
FIG. 3A to FIG. 3B are schematic views of the substrate of a packaged structure according to an embodiment of the present invention.
FIG. 4 is a schematic structural view of the substrate of a packaged structure according to an embodiment of the present invention.
FIG. 5 is a schematic structural view of the substrate of a packaged structure according to an embodiment of the present invention.
FIG. 6 is a schematic structural view of the substrate of a packaged structure according to an embodiment of the present invention.

### DESCRIPTION OF EMBODIMENTS

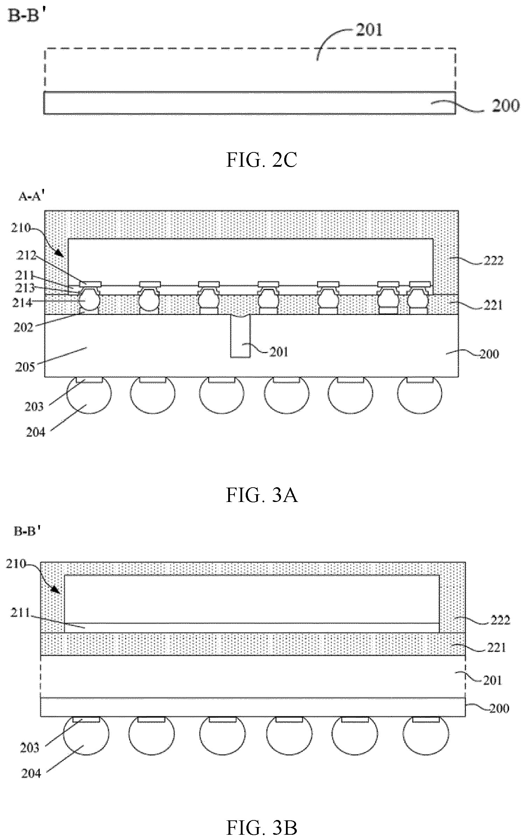

Referring to FIG. 2A to FIG. 2C, they are schematic structural views of the substrate of a packaged structure according to an embodiment of the present invention. FIG. 2A is a schematic top view of the substrate, FIG. 2B is a schematic cross-sectional view of the substrate along the direction of A-A' in FIG. 2A, and FIG. 2C is a schematic cross-sectional view of the substrate along the direction of B-B' in FIG. 2A.

The package structure includes a substrate 200. The substrate 200 has a first surface and a second surface opposite to each other. The first surface is used for fastening a chip, and the second surface is used for forming solder balls thereon to connect to another circuit board.

The substrate 200 may be a circuit board. Electrical connection structures such as an interconnection circuit and a solder pad (not shown in the drawings) may be formed on the surface of the substrate 200 and/or in the substrate 200 to electrically connect to the chip to input an electrical signal into the chip or to output an electrical signal generated by the chip.

The first surface of the substrate 200 includes a one strip-shaped groove 201 having two ends extending to the edges of the substrate 200 and open to the exterior. The depth of the groove 201 is smaller than the thickness of the substrate.

In some embodiments, the groove 201 may be a long straight groove having the uniform width. The bottom of the groove 201 is located in the substrate 200. The groove 201 serves as a path for removing gas inside the packaged structure in the injection molding process of the packaged chip. The gas may be removed from the two ends of the groove 201 at the edges of the substrate 200 and open to the exterior. To prevent an injection molding material from entering into the groove 201 in the injection molding process to block the groove 201 and adversely affect the gas removal, the width of the groove 201 is smaller than the fillable width of the injection molding material in the liquid state. When the width of the groove 201 is smaller than the fillable width, the liquid-state injection molding material cannot be filled in the groove 201 under the action of surface tension due to the relatively high viscosity of the injection molding material. Specifically, the width of the groove 201 may be smaller than 4 µm, and may be, preferably 2 µm, or may be 3 µm, 1 µm. A person skilled in the art can reasonably set the width of the groove 201 under the condition that the width of the groove 201 is smaller than the fillable width, so that the groove 201 may have better gas removal efficiency while preventing the injection molding material from entering the groove 201.

The area of a cross-section of the groove 201 in the direction perpendicular to the length direction may determine the gas removal efficiency. When the width of the groove 201 is limited, the depth of the groove 201 may be set to adjust the gas removal efficiency of the groove 201. The depth of the groove 201 is smaller than the depth of the substrate 200 to maintain the integrity of the second surface of the substrate 200, so that the distribution of structures such as solder bumps and solder balls on the second surface of the substrate 200 may not be affected.

The depth of the groove 201 may not be too large to prevent the strength of the substrate 200 from being adversely affected and causing problems such as breakage. In some embodiments, the depth of the groove 201 may be in the range of 1% to 70% of the thickness of the substrate 200. In some embodiments, the depth of the groove 201 may be in the range of 80 µm to 0.5 mm.

In some embodiments, the substrate 200 may in a shape of a rectangular. The length direction of the groove 201 is consistent with the direction of the long side direction of the substrate 200. Since gas is more difficult to be removed in the injection molding process along the long side of the substrate, disposing the groove 201 along the long side of the substrate 200 may improve the gas removal efficiency. In some other embodiments, when the substrate is in the shape of the rectangular, there may be at least one groove extending along the length direction of the substrate.

In some embodiments, the groove 201 may be disposed on a symmetry axis of the substrate 200, thereby improving the structural symmetry of the substrate 200, the symmetry of internal stress distribution in the substrate 200, and the stability of the packaged structure.

FIG. 3A and FIG. 3B are schematic cross-sectional views of the packaged structure along the direction of A-A' and B-B' of the substrate, respectively, according to an embodiment of the present invention.

The packaged structure includes the substrate 200, a chip 210, a bottom filling layer 221 filling the gap between the chip 210 and the substrate 200, and a plastic packaging layer 222 covering the bottom filling layer 221 and wrapping the chip 210.

In some embodiments, the bottom filling layer 221 may fill between the chip 210 and the substrate 200 and may further cover the portion of the substrate 200 that is not occupied by the chip 210. The plastic packaging layer 222 may cover the surface of the bottom filling layer 221. In some other embodiments, the edges of the substrate 200 may not be covered by the bottom filling layer 221, but instead be directly covered by the plastic packaging layer 222. And the plastic packaging layer 222 may cover a portion of the surface and side walls of the bottom filling layer 221. In some other embodiments, the bottom filling layer 221 may be located only under the chip 210, and the plastic packaging layer 222 may cover the side walls of the bottom filling layer 221.

The chip 210 is fastened onto the first surface of the substrate 200 in a flipping manner by using solder bumps and is electrically connected to the substrate 200 through the solder bumps. At least a portion of the groove 201 is located in the projection of the chip 210 on the substrate 200.

Specifically, the surface of the chip 210 may have a passivation layer 211 covering the solder pads 212 of the chip 210. The solder bump may include a lower bump metal layer 213 located in the passivation layer 211 and formed on the surface of the solder pad 212, and a solder ball 214 formed on the surface of the lower bump metal layer 213. In some other embodiments, the solder bump may further include structures such as a metal rod. The solder ball 214 may be connected to a circuit in the chip 210 through the solder pad 212.

The first surface of the substrate 200 may include a connection structure 202, such as a solder pad or a metal wire. The chip 210 may be fastened to the connection structure 202 by soldering through the solder ball 214 to implement an electrical connection. The second surface of the substrate 200 may include a connection structure 203 and a solder ball 204 formed on the connection structure 203. The solder ball 204 may be configured to weld the packaged structure onto another circuit board. The substrate 200 may further include an interconnection structure 205 such as a connection rod penetrating through the substrate 200, configured to form an electrical connection between the connection structure 202 on the first surface and the connection structure 203 on the second surface of the substrate 200.

The circuit connection mode in the substrate 200 may be designed according to a specific chip, which is not limited herein.

Because the width of the groove 201 is smaller than the fillable width of the material of the bottom filling layer 211 in the liquid state, the bottom filling layer 221 of the packaged structure seals only the opening on the top of the groove 201 without filling the groove 201. There is a continuous gas path formed in the groove 201. Thus, the groove 201 may effectively remove gas when forming the bottom filling layer 211 through injection molding.

Because the bottom of the groove 201 is located in the substrate 200, the distribution and the area of the connection region on the second surface of the substrate 200 is not adversely affected, and the entire second surface of the substrate 200 may be used as a connection region for connecting to another circuit board and for forming the solder balls 204. The solder balls 204 may be distributed more flexibly and the internal circuit wiring may be more flexible in the substrate 200. For example, a larger spacing between the solder balls 204 may be set, thereby reducing the soldering difficulty in the subsequent mounting of the packaged structure onto other circuit boards.

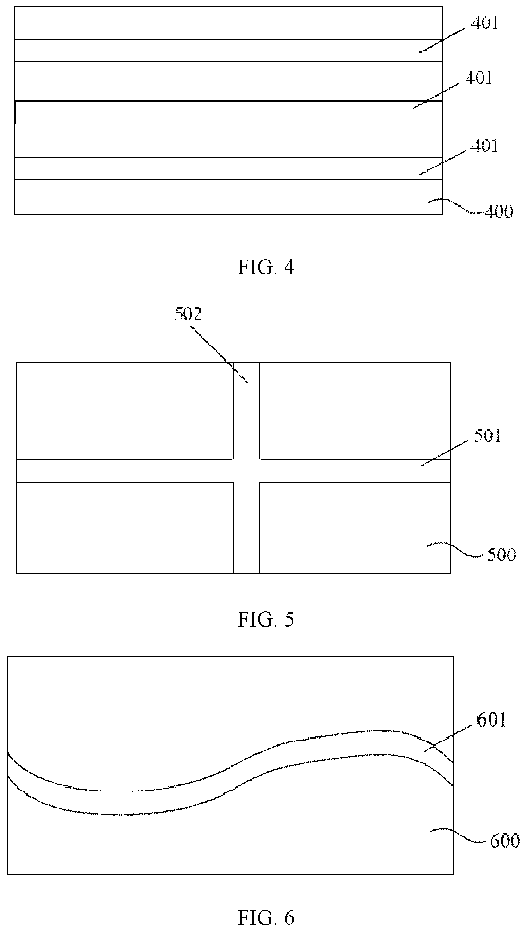

FIG. 4 is a schematic top view of a substrate 400 used in a packaged structure according to another embodiment of the present invention.

In some embodiments, the substrate 400 has three strip-shaped grooves 401 arranged parallelly formed on the surface of the substrate 400. All the three grooves 401 may have a shape of a long rectangle and may be evenly distributed in the substrate 400. Additionally, one of the grooves 401 may be disposed at the position of a symmetry axis of the substrate 400.

Excessively large spacing between the adjacent grooves 401 may reduce the gas removal efficiency, resulting in the gas not being removed in time, and excessively small spacing between the adjacent grooves 401 can cause uneven internal stress distribution of the substrate 400, thereby adversely affecting the strength of the substrate 400. Preferably, the spacing between the adjacent grooves 401 may be in the range of 50 µm to 5 mm, so as to achieve relatively good gas removal efficiency while keeping the sufficient strength of the substrate 400. A person skilled in the art can reasonably set the spacing between the adjacent grooves 401 based on factors such as the actual thickness and size of the substrate while achieving relatively good gas removal efficiency.

In other embodiments, the substrate of the packaged structure may include two or more grooves to improve the gas removal efficiency during injection molding. The grooves may be arranged parallelly or connected crossly and have different depths and widths. The groove may have a cross-section with a shape of a rectangular, a circle, or an oval.

FIG. 5 is a schematic top view of the substrate 500 used in a packaged structure according to yet another embodiment of the present invention.

In some embodiments, the substrate 500 includes a groove 501 and a groove 502. The groove 501 may be disposed along the long side of the substrate 500, and the groove 502 may be disposed along the short side of the substrate 500. The groove 501 and the groove 502 may be disposed at the positions of two symmetry axes of the substrate 500, respectively. The groove 501 and the groove 502 may be connected vertically.

Referring to FIG. 6, in some embodiments, the substrate 600 has a groove 601. The groove 601 may have a curved shape. The curved shape of the groove 601 may increase the length of the groove 601, so that the groove may occupy more area under a chip, thereby facilitating the removal of the gas.

Embodiments of the present invention provide a forming method for the foregoing packaged structure.

The forming method for the foregoing packaged structure includes the following steps.

At step 1, a packaged chip is provided. The packaged chip includes a substrate and a chip fastened onto the substrate. The substrate has a first surface and a second surface opposite to each other. The first surface includes at least one groove. The chip is fastened onto the first surface of the substrate in a flipping manner by using solder bumps. The solder bumps are electrically connected to the substrate. At least a portion of the groove is located in the projection of the chip on the substrate.

The at least one groove is strip-shaped and has two ends extending to the edges of the substrate and open to the exterior. The depth of the groove is smaller than the thickness of the substrate.

Preferably, the first surface of the substrate may include at least two grooves arranged parallelly or crossly.

Preferably, the width of the groove may be smaller than 4 µm.

Preferably, the depth of the groove may be in the range of 1% to 70% of the thickness of the substrate. In some embodiments, the depth of the groove may be in the range of 80 µm to 0.5 mm.

Preferably, the groove may be straight or curved.

Preferably, the at least one groove may be located at the position of a symmetry axis of the substrate.

Preferably, when the substrate may have a rectangular shape, the at least one groove may extend along the long side of the substrate.

The description of the foregoing embodiments may be referred to for the detail of the groove, which will not be repeatedly described herein.

At step 2, injection molding is performed on the packaged chip to form a bottom filling layer filling the gap between the chip and the first surface of the substrate, and a plastic packaging layer covering the bottom filling layer and packaging the chip.

Because the gap between the substrate and the chip is relatively small, the capillary effect may be used. After providing a bottom filler at the edges of the substrate, the capillary effect may be used to cause the bottom filler to automatically fill in the gap between the chip and the substrate. In the filling process, the gas between the chip and the substrate may be removed from the edges of the substrate through the groove in the first surface of the substrate.

Specifically, in some embodiments, performing injection molding on the packaged chip includes the following operations. An injection mold is provided. The injection mold includes an under-pan and a cover configured to cover the under-pan to form a cavity with the under-pan. The packaged chip is placed in the cavity. The substrate is placed on the surface of the under-pan. Using the capillary effect, the bottom filler is filled in the gap between the bottom of the chip and the substrate. A liquid-state plastic packaging material is injected into the cavity until the cavity is filled with the liquid-state plastic packaging material. Heating treatment is preformed to solidify the liquid-state plastic packaging material and the bottom filler, to form the solid-state plastic packaging layer and bottom filling layer. The bottom filling layer and the plastic packaging layer may be made of the same injection molding material or different injection molding material.

The cover may include at least one hole connecting the cavity to the outside. And the method may further include an operation of injecting the liquid-state plastic packaging material into the cavity through the at least one hole. In some embodiments, the cover may include a separable side wall and top cover. The at least one hole may be disposed in the side wall. The bottom filler and the liquid-state plastic packaging material may be injected into the cavity through the hole. Specifically, the bottom filler may first be slowly injected into the cavity through the hole. After reaching the substrate, the bottom filler may be filled between the chip and the substrate by using the capillary effect. Then, the liquid-state plastic packaging material may be injected to fill with the entire cavity.

In some embodiments, the cover may include at least two holes. And the method may further include an operation of removing the gas inside the cavity through at least one of the holes in the injection molding process. The hole configured to remove gas may be disposed in the side wall or the top cover of the cover.

In the injection molding process, because the width of the groove is smaller than the fillable width of the bottom filler in the liquid state, the liquid-state plastic packaging material only seals the top of the groove, without filling the groove, to form a continuous gas path in the groove. And the groove may effectively remove gas in the injection molding process.

In the foregoing embodiments, after placing the packaged chip into the packaging mold, the filling layer may be formed by using the capillary effect. Then the plastic packaging layer may be formed by using the plastic packaging material to fill the cavity.

In some other embodiments, before placing the packaged chip into the packaging mold, the filling layer may be first formed between the chip and the substrate by using the capillary effect. Then the packaged chip may be placed into the packaging mold to form the plastic packaging layer wrapping the upper portion of the chip.

At step 3, solder balls may be formed on the second surface of the substrate after taking the injection-molded packaged chip from the cavity. The solder balls may be distributed on the entire second surface of the substrate.

The solder balls may be lead solder balls, lead-free solder ball or the like. Subsequently, the packaged structure may be mounted onto other electronic components such as a circuit board by using the solder balls 203 through a reflow soldering process.

In the embodiments of the present invention, a plurality of chips may be formed on the surface of the substrate, and plastic packaging may be performed on the plurality of chips and the substrate. After the plastic packaging is completed, structures such as solder balls may be further formed on the second surface of the substrate and the packaged structure shown in FIG. 3A may be formed by cutting.

According to the forming method of the packaged structure, in the injection molding process, the gas in the packaged structure may be removed through the groove having the ends in the substrate and open to the exterior. Because the depth of the groove is smaller than the depth of the substrate, it will not affect the second surface of the substrate, and will not occupy the area used to form the solder balls on the second surface.

Further, because the width of the groove is relatively small, the bottom filler in the injection molding process does not fill the groove, thereby preventing the groove from being blocked and improving the gas removal efficiency of the groove.

The foregoing descriptions are some embodiments of the present invention. A person of ordinary skills in the art may further make various improvements or modifications without departing from the scope of the present invention, which is defined by the appended claims.

## Claims

1. A packaged structure, comprising:
a substrate (200, 400, 500, 600) having a first surface and a second surface opposite to each other, the first surface having at least one strip-shaped groove (201, 401, 501, 502, 601) having two ends extending to edges of the substrate (200, 400, 500, 600) and open to exterior, a depth of the groove being smaller than a thickness of the substrate (200, 400, 500, 600);
a chip (210) fastened onto the first surface of the substrate (200) in a flipping manner by using solder bumps and electrically connected to the substrate (200, 400, 500, 600) through the solder bumps, at least a portion of the groove (201, 401, 501, 502, 601) located within a projection of the chip (210) on the substrate (200, 400, 500, 600);
a bottom filling layer (221) filling a gap between the chip (210) and the first surface of the substrate (200, 400, 500, 600); and
a plastic packaging layer (222), covering the bottom filling layer (221) and wrapping the chip (210);
wherein a width of the groove (201, 401, 501, 502, 601) is smaller than a fillable width of the material of the bottom filling layer (221) in a liquid state, and a top of the groove (201, 401, 501, 502, 601) is sealed by the bottom filling layer (221), and the groove (201, 401, 501, 502, 601) has a continuous gas path formed in the groove (201, 401, 501, 502, 601).

2. The packaged structure of claim 1, **characterized in that** the first surface of the substrate (200) comprises at least two grooves arranged parallelly or crossly.

3. The packaged structure of claim 1, **characterized in that** the width of the groove (201, 401, 501, 502, 601) is smaller than 4 µm.

4. The packaged structure of claim 1, **characterized in that** the depth of the groove (201, 401, 501, 502, 601) is in a range of 1% to 70% of the thickness of the substrate (200, 400, 500, 600); or the depth of the groove (201, 401, 501, 502, 601) is in a range of 80 µm to 0.5 mm.

5. The packaged structure of claim 1, **characterized in that** the groove (201, 401, 501, 502, 601) is straight or curved.

6. The packaged structure of claim 1, **characterized in that** the at least one groove (201, 401, 501, 502, 601) is located at a position of a symmetry axis of the substrate (200, 400, 500, 600).

7. The packaged structure of claim 1, **characterized in that** the packaged structure further comprises solder balls (214), formed on the second surface of the substrate (200, 400, 500, 600).

8. A forming method of a packaged structure, comprising:
providing a packaged chip, wherein the packaged chip comprises a substrate (200, 400, 500, 600) and a chip (210), the substrate (200, 400, 500, 600) has a first surface and a second surface opposite to each other, at least one strip-shaped groove (201, 401, 501, 502, 601) is formed in the first surface of the substrate (200, 400, 500, 600), the chip (210) is fastened onto the first surface of the substrate (200, 400, 500, 600) in a flipping manner by using solder bumps, the solder bumps are electrically connected to the substrate (200, 400, 500, 600), and at least a portion of the groove (201, 401, 501, 502, 601) is located in a projection of the chip (210) on the substrate (200, 400, 500, 600), wherein the groove (201, 401, 501, 502, 601) has two ends extending to edges of the substrate (200, 400, 500, 600) and open to exterior, and has a depth smaller than a thickness of the substrate (200, 400, 500, 600) ; and
performing injection molding on the packaged chip to form a bottom filling layer (221) filling a gap between the chip (210) and the first surface of the substrate (200, 400, 500, 600), and a plastic packaging layer (222) covering the bottom filling layer (221) and wrapping the chip (210), wherein in the injection molding process, since a width of the groove (201, 401, 501, 502, 601) is smaller than a fillable width of the liquid-state plastic packaging material, the bottom filler only seals a top of the groove (201, 401, 501, 502, 601) without filling the groove(201, 401, 501, 502, 601) to form a continuous gas path in the groove (201, 401, 501, 502, 601).

9. The forming method of claim 8, **characterized in that** gas is removed through the groove (201, 401, 501, 502, 601) in a process of forming the bottom filling layer (221).

10. The forming method of claim 8, **characterized in that** the performing injection molding on the packaged chip comprises:
providing an injection mold, wherein the injection mold comprises an under-pan and a cover, and the cover is configured to cover the under-pan to form a cavity with the under-pan;
placing the packaged chip in the cavity, wherein the substrate (200, 400, 500, 600) is placed on the surface of the under-pan;
filling, using a capillary effect, a bottom filler in the gap between the bottom of the chip (210) and the substrate (200, 400, 500, 600);
injecting a liquid-state plastic packaging material into the cavity until the cavity is filled with the liquid-state plastic packaging material; and
performing heating treatment to solidify the liquid-state plastic packaging material and the bottom filler, to form a solid-state plastic packaging layer and the bottom filling layer.

11. The forming method of claim 10, **characterized in that** the cover comprises at least one hole connecting the cavity to outside, and the method further comprises:
injecting, through the at least one hole, the liquid-state plastic packaging material into the cavity.

12. The forming method of claim 11, **characterized in that** the cover comprises at least two holes, and the method further comprises:
removing gas inside the cavity through at least one of the holes in an injection molding process.

13. The forming method of claim 8, further comprising:
forming solder balls on the second surface of the substrate (200, 400, 500, 600).

## Patentansprüche

1. Package-Struktur, die umfasst:
ein Substrat (200, 400, 500, 600) mit einer ersten Oberfläche und einer zweiten Oberfläche, die einander gegenüberliegen, wobei die erste Oberfläche wenigstens eine streifenförmige Nut (201, 401, 501, 502, 601) aufweist, die zwei Enden aufweist, die sich zu den Rändern des Substrats (200, 400, 500, 600) erstrecken und nach außen offen sind, wobei eine Tiefe der Nut kleiner als eine Dicke des Substrats (200, 400, 500, 600) ist;
einen Chip (210), der auf der ersten Oberfläche des Substrats (200) kippend unter Verwendung von Lotkugeln befestigt und mit dem Substrat (200, 400, 500, 600) durch die Lotkugeln elektrisch verbunden ist, wobei wenigstens ein Teil der Nut (201, 401, 501, 502, 601) innerhalb eines Vorsprungs des Chips (210) auf dem Substrat (200, 400, 500, 600) angeordnet ist;
eine untere Füllschicht (221), die einen Spalt zwischen dem Chip (210) und der ersten Oberfläche des Substrats (200, 400, 500, 600) füllt; und
eine Kunststoffpackungsschicht (222), die die untere Füllschicht (221) bedeckt und den Chip (210) umhüllt;
wobei eine Breite der Nut (201, 401, 501, 502, 601) kleiner ist als eine füllbare Breite des Materials der unteren Füllschicht (221) in einem flüssigen Zustand, und eine Oberseite der Nut (201, 401, 501, 502, 601) durch die untere Füllschicht (221) versiegelt ist, und die Nut (201, 401, 501, 502, 601) einen kontinuierlichen Gasweg aufweist, der in der Nut (201, 401, 501, 502, 601) ausgebildet ist.

2. Package-Struktur nach Anspruch 1, **dadurch gekennzeichnet, dass** die erste Oberfläche des Substrats (200) wenigstens zwei parallel oder kreuzweise angeordnete Nuten umfasst.

3. Package-Struktur nach Anspruch 1, **dadurch gekennzeichnet, dass** die Breite der Nut (201, 401, 501, 502, 601) kleiner als 4 µm ist.

4. Package-Struktur nach Anspruch 1, **dadurch gekennzeichnet, dass** die Tiefe der Nut (201, 401, 501, 502, 601) in einem Bereich von 1 % bis 70 % der Dicke des Substrats (200, 400, 500, 600) liegt; oder die Tiefe der Nut (201, 401, 501, 502, 601) in einem Bereich von 80 pm bis 0,5 mm liegt.

5. Package-Struktur nach Anspruch 1, **dadurch gekennzeichnet, dass** die Nut (201, 401, 501, 502, 601) gerade oder gekrümmt ist.

6. Package-Struktur nach Anspruch 1, **dadurch gekennzeichnet, dass** sich die wenigstens eine Nut (201, 401, 501, 502, 601) an einer Position einer Symmetrieachse des Substrats (200, 400, 500, 600) befindet.

7. Package-Struktur nach Anspruch 1, **dadurch gekennzeichnet, dass** die verpackte Struktur ferner Lötkugeln (214) umfasst, die auf der zweiten Oberfläche des Substrats (200, 400, 500, 600) ausgebildet sind.

8. Formgebungsverfahren zur Herstellung einer Package-Struktur, umfassend:
Bereitstellen eines verpackten Chips, wobei der verpackte Chip ein Substrat (200, 400, 500, 600) und einen Chip (210) umfasst, das Substrat (200, 400, 500, 600) eine erste Oberfläche und eine zweite Oberfläche aufweist, die einander gegenüberliegen, wenigstens eine streifenförmige Nut (201, 401, 501, 502, 601) in der ersten Oberfläche des Substrats (200, 400, 500, 600) ausgebildet ist, der Chip (210) auf der ersten Oberfläche des Substrats (200, 400, 500, 600) auf invertierte Weise unter Verwendung von Lotkugeln befestigt ist, die Lotkugeln mit dem Substrat (200, 400, 500, 600) elektrisch verbunden sind, und wenigstens ein Teil der Nut (201, 401, 501, 502, 601) in einer Projektion des Chips (210) auf das Substrat (200, 400, 500, 600) liegt, wobei sich die Nut (201, 401, 501, 502, 601) in einer Projektion des Chips (210) auf das Substrat (200, 400, 500, 600) befindet, wobei die Nut (201, 401, 501, 502, 601) zwei Enden aufweist, die sich zu Rändern des Substrats (200, 400, 500, 600) erstrecken und nach außen offen sind, und eine Tiefe aufweist, die kleiner als eine Dicke des Substrats (200, 400, 500, 600) ist; und
Durchführen eines Spritzgießens an dem verpackten Chip, um eine untere Füllschicht (221), die einen Spalt zwischen dem Chip (210) und der ersten Oberfläche des Substrats (200, 400, 500, 600) füllt, und eine Kunststoffverpackungsschicht (222), die die untere Füllschicht (221) bedeckt und den Chip (210) umhüllt, zu bilden, wobei in dem Spritzgießprozess, da eine Breite der Nut (201, 401, 501, 502, 601) kleiner als eine füllbare Breite des Kunststoffverpackungsmaterials im flüssigen Zustand ist, der untere Füllstoff nur eine Oberseite der Nut (201, 401, 501, 502, 601) abdichtet, ohne die Nut (201, 401, 501, 502, 601) zu füllen, um einen kontinuierlichen Gasweg in der Nut (201, 401, 501, 502, 601) zu bilden.

9. Formgebungsverfahren nach Anspruch 8, **dadurch gekennzeichnet, dass** Gas durch die Nut (201, 401, 501, 502, 601) in einem Prozess der Bildung der unteren Füllschicht (221) entfernt wird.

10. Formgebungsverfahren nach Anspruch 8, **dadurch gekennzeichnet, dass** die Durchführung des Spritzgießens an dem verpackten Chip umfasst:
Bereitstellen einer Spritzgussform, wobei die Spritzgussform eine Unterschale und eine Abdeckung umfasst und die Abdeckung so ausgelegt ist, dass sie die Unterschale abdeckt, um einen Hohlraum mit der Unterschale zu bilden;
Einsetzen des verpackten Chips in den Hohlraum, wobei das Substrat (200, 400, 500, 600) auf die Oberfläche der Unterschale gelegt wird;
Einfüllen eines unteren Füllstoffs in den Spalt zwischen der Unterseite des Chips (210) und dem Substrat (200, 400, 500, 600) unter Verwendung des Kapillareffekts;
Einspritzen eines Kunststoffverpackungsmaterials im flüssigen Zustand in den Hohlraum, bis der Hohlraum mit dem Kunststoffverpackungsmaterial im flüssigen Zustand gefüllt ist; und
Durchführen einer Wärmebehandlung, um das Kunststoffverpackungsmaterial im flüssigen Zustand und den Bodenfüller zu verfestigen, um eine Kunststoffverpackungsschicht im festen Zustand und die untere Füllschicht zu bilden.

11. Formgebungsverfahren nach Anspruch 10, **dadurch gekennzeichnet, dass** die Abdeckung wenigstens ein Loch aufweist, das den Hohlraum mit der Außenseite verbindet, und dass das Verfahren ferner umfasst:
Einspritzen des Kunststoffverpackungsmaterials im flüssigen Zustand durch das wenigstens eine Loch in den Hohlraum.

12. Formgebungsverfahren nach Anspruch 11, **dadurch gekennzeichnet, dass** die Abdeckung wenigstens zwei Löcher umfasst, und das Verfahren ferner umfasst:
Entfernen von Gas innerhalb des Hohlraums durch wenigstens eines der Löcher in einem Spritzgießprozess.

13. Formgebungsverfahren nach Anspruch 8, das ferner umfasst:
Ausbilden von Lötkugeln auf der zweiten Oberfläche des Substrats (200, 400, 500, 600).

## Revendications

1. Structure encapsulée, comprenant :
un substrat (200, 400, 500, 600) ayant une première surface et une deuxième surface opposées l'une à l'autre, la première surface ayant au moins une rainure (201, 401, 501, 502, 601) en forme de bande ayant deux extrémités s'étendant vers des bords du substrat (200, 400, 500, 600) et ouvertes vers l'extérieur, une profondeur de la rainure étant plus petite qu'une épaisseur du substrat (200, 400, 500, 600) ;
une puce (210) fixée sur la première surface du substrat (200) d'une manière retournée en utilisant des perles de soudure et connectée électriquement au substrat (200, 400, 500, 600) par le biais des perles de soudure, au moins une partie de la rainure (201, 401, 501, 502, 601) étant située dans une projection de la puce (210) sur le substrat (200, 400, 500, 600) ;
une couche de remplissage de fond (221) remplissant un espace entre la puce (210) et la première surface du substrat (200, 400, 500, 600) ; et
une couche d'encapsulation en plastique (222), recouvrant la couche de remplissage de fond (221) et enveloppant la puce (210) ;
dans laquelle une largeur de la rainure (201, 401, 501, 502, 601) est plus petite qu'une largeur remplissable du matériau de la couche de remplissage de fond (221) dans un état liquide, et un dessus de la rainure (201, 401, 501, 502, 601) est fermé hermétiquement par la couche de remplissage de fond (221), et la rainure (201, 401, 501, 502, 601) a un chemin de gaz continu formé dans la rainure (201, 401, 501, 502, 601).

2. Structure encapsulée selon la revendication 1, **caractérisée en ce que** la première surface du substrat (200) comprend au moins deux rainures agencées parallèlement ou en croix.

3. Structure encapsulée selon la revendication 1, **caractérisée en ce que** la largeur de la rainure (201, 401, 501, 502, 601) est plus petite que 4 µm.

4. Structure encapsulée selon la revendication 1, **caractérisée en ce que** la profondeur de la rainure (201, 401, 501, 502, 601) est dans une plage de 1 % à 70 % de l'épaisseur du substrat (200, 400, 500, 600) ; ou la profondeur de la rainure (201, 401, 501, 502, 601) est dans une plage de 80 µm à 0,5 mm.

5. Structure encapsulée selon la revendication 1, **caractérisée en ce que** la rainure (201, 401, 501, 502, 601) est droite ou incurvée.

6. Structure encapsulée selon la revendication 1, **caractérisée en ce que** l'au moins une rainure (201, 401, 501, 502, 601) est située à une position d'un axe de symétrie du substrat (200, 400, 500, 600).

7. Structure encapsulée selon la revendication 1, **caractérisée en ce que** la structure encapsulée comprend en outre des billes de soudure (214), formées sur la deuxième surface du substrat (200, 400, 500, 600).

8. Méthode de formation d'une structure encapsulée, comprenant :
la fourniture d'une puce encapsulée, dans laquelle la puce encapsulée comprend un substrat (200, 400, 500, 600) et une puce (210), le substrat (200, 400, 500, 600) a une première surface et une deuxième surface opposées l'une à l'autre, au moins une rainure (201, 401, 501, 502, 601) en forme de bande est formée dans la première surface du substrat (200, 400, 500, 600), la puce (210) est fixée sur la première surface du substrat (200, 400, 500, 600) d'une manière retournée en utilisant des perles de soudure, les perles de soudure sont connectées électriquement au substrat (200, 400, 500, 600), et au moins une partie de la rainure (201, 401, 501, 502, 601) est située dans une projection de la puce (210) sur le substrat (200, 400, 500, 600), dans laquelle la rainure (201, 401, 501, 502, 601) a deux extrémités s'étendant vers des bords du substrat (200, 400, 500, 600) et ouvertes vers l'extérieur, et a une profondeur plus petite qu'une épaisseur du substrat (200, 400, 500, 600) ; et
la réalisation d'un moulage par injection sur la puce encapsulée pour former une couche de remplissage de fond (221) remplissant un espace entre la puce (210) et la première surface du substrat (200, 400, 500, 600), et une couche d'encapsulation en plastique (222) recouvrant la couche de remplissage de fond (221) et enveloppant la puce (210), dans laquelle dans le procédé de moulage par injection, puisqu'une largeur de la rainure (201, 401, 501, 502, 601) est plus petite qu'une largeur remplissable du matériau d'encapsulation en plastique à l'état liquide, l'agent de remplissage de fond ne ferme hermétiquement qu'un dessus de la rainure (201, 401, 501, 502, 601) sans remplir la rainure (201, 401, 501, 502, 601) pour former un chemin de gaz continu dans la rainure (201, 401, 501, 502, 601) .

9. Méthode de formation selon la revendication 8, **caractérisée en ce que** du gaz est retiré par le biais de la rainure (201, 401, 501, 502, 601) dans un procédé de formation de la couche de remplissage de fond (221).

10. Méthode de formation selon la revendication 8, **caractérisée en ce que** la réalisation d'un moulage par injection sur la puce encapsulée comprend :
la fourniture d'un moule pour injection, dans laquelle le moule pour injection comprend une cuvette inférieure et un couvercle, et le couvercle est configuré pour recouvrir la cuvette inférieure pour former une cavité avec la cuvette inférieure ;
le placement de la puce encapsulée dans la cavité, dans laquelle le substrat (200, 400, 500, 600) est placé sur la surface de la cuvette inférieure ;
le remplissage, en utilisant un effet capillaire, avec un agent de remplissage de fond, de l'espace entre le fond de la puce (210) et le substrat (200, 400, 500, 600) ;
l'injection d'un matériau d'encapsulation en plastique à l'état liquide dans la cavité jusqu'à ce que la cavité soit remplie du matériau d'encapsulation en plastique à l'état liquide ; et
la réalisation d'un traitement de chauffage pour solidifier le matériau d'encapsulation en plastique à l'état liquide et l'agent de remplissage de fond, pour former une couche d'encapsulation en plastique à l'état solide et la couche de remplissage de fond.

11. Méthode de formation selon la revendication 10, **caractérisée en ce que** le couvercle comprend au moins un trou reliant la cavité au dehors, et la méthode comprend en outre :
l'injection, à travers l'au moins un trou, du matériau d'encapsulation en plastique à l'état liquide dans la cavité.

12. Méthode de formation selon la revendication 11, **caractérisée en ce que** le couvercle comprend au moins deux trous, et la méthode comprend en outre :
le retrait de gaz à l'intérieur de la cavité par le biais d'au moins un des trous dans un procédé de moulage par injection.

13. Méthode de formation selon la revendication 8, comprenant en outre :
la formation de billes de soudure sur la deuxième surface du substrat (200, 400, 500, 600).
